# EUROPÄISCHE PATENTSCHRIFT

(11) **EP 1 861 694 B1**
(45) Veröffentlichungstag und Bekanntmachung des Hinweises auf die Patenterteilung: **12.06.2013**
(21) Anmeldenummer: 06723546.5
(22) Anmeldetag: 20.03.2006
(51) Int. Cl.: G01N 21/64, G03F 7/20, G03F 7/105, G02B 21/00, G01N 21/956

(54) **VERFAHREN ZUR HERSTELLUNG RÄUMLICHER FEINSTRUKTUREN**
METHOD FOR PRODUCING THREE-DIMENSIONAL FINE STRUCTURES
Procédé pour réaliser des structures tridimensionnelles fines

(30) Priorität: 19.03.2005 DE 102005012739
(43) Veröffentlichungstag der Anmeldung: 05.12.2007
(73) Patentinhaber: Max-Planck-Gesellschaft zur Förderung der Wissenschaften e.V., 80539 München (DE)
(72) Erfinder: HELL, Stefan, 37085 Göttingen (DE); WESTPHAL, Volker, 30161 Hannover (DE); QUAAS, Norbert, 28209 Bremen (DE)
(74) Vertreter: Rehberg Hüppe + Partner
(86) Internationale Anmeldenummer: PCT/EP2006/002526
(87) Internationale Veröffentlichungsnummer: WO 2006/100013

(56) Entgegenhaltungen:
- WO-A2-95/21393
- US-A- 5 777 342
- US-A1- 2003 036 006
- US-B1- 6 259 104

## Beschreibung

Die Erfindung betrifft ein Verfahren zur Herstellung räumlicher Feinstrukturen mit den Schritten des Oberbegriffs des Patentanspruchs 1. Bei den hergestellten Feinstrukturen handelt es sich um künstliche, d. h. von Menschenhand hergestellte Feinstrukturen. Insbesondere betrifft die Erfindung derartige Verfahren, bei denen die räumlichen Feinstrukturen lithographisch erzeugt werden.

Unter einer Feinstruktur im Sinne der vorliegenden Beschreibung sind insbesondere Mikrostrukturen und Nanostrukturen, d. h. Strukturen mit Detailabmessungen im Mikrometer und Nanometerbereich zu verstehen.

### STAND DER TECHNIK

Verfahren zur lithographischen Herstellung räumlicher Feinstrukturen mit den Schritten Ausbilden einer räumlichen Feinstruktur aus einem Material und mikroskopisch Überprüfen, ob die gewünschte Feinstruktur vorliegt, werden bei der Herstellung von elektronischen Halbleiterbauteilen zur Ausbildung feiner Leiterstrukturen oder Isolatorstrukturen angewendet. Hierzu wird beispielsweise auf ein Substrat aus einem Halbleiter eine Schicht aus einem strahlungsempfindlichen Material aufgetragen. Die Strahlungsempfindlichkeit dieses Materials bezieht sich darauf, dass es mit einer Strahlung so in seinem Zustand verändert werden kann, dass es beispielsweise möglich ist, die bestrahlten Bereiche der Schicht leicht mit einem Lösungsmittel zu entfernen, während die unbestrahlten Bereiche der Schicht zuverlässig zurückbleiben. Als Basis für geeignete strahlungsempfindliche Materialien werden beispielsweise verschiedene phenolische Harze, akrylische Polymere, alizyklische Polymere und Fluorpolymere verwendet. Diese Materialien sind jeweils gegenüber einer elektromagnetischen Strahlung aus einem bestimmten Wellenlängenbereich besonders empfindlich, der vom mittleren UV-Bereich bis zum Röntgenbereich reichen kann. Die Strahlungsempfindlichkeit des Materials der Schicht beruht beispielsweise auf photoinduzierter lokaler Azidierung oder, dazu komplementär, photoinduzierter lokaler Vernetzung; sie kann sich aber zum Beispiel auch auf eine Empfindlichkeit des Materials gegenüber Elektronenstrahlung oder anderen Teilchenstrahlen beziehen. In jedem Fall wird bei dem bekannten Verfahren die auf das Substrat aufgetragene Schicht in definierten räumlichen Bereichen bestrahlt, um das Material in diesen räumlichen Bereichen im Gegensatz zu den nicht bestrahlten Bereichen umzuwandeln, so dass diese Bereiche des Materials voneinander unterscheidbar sind. Anschließend erfolgt ein Entwickeln der bestrahlten Schicht, bei dem im Regelfall das Material aus den definierten räumlichen Bereichen, in denen die Schicht bestrahlt wurde, entfernt wird. Grundsätzlich kann das Entwickeln aber auch dazu führen, dass das Material der Schicht in den nicht bestrahlten Bereichen entfernt wird. Zur Kontrolle, dass die Schicht auf diesem Wege die gewünschte Feinstruktur erhalten hat, wird diese bei dem aus der Fabrikation elektronischer Halbleiterbauteile bekannten Verfahren durch Elektronenmikroskopie auf das Vorliegen der gewünschten Feinstruktur untersucht. Die Elektronenmikroskopie wird eingesetzt, um die erzielte Feinstruktur möglichst hoch räumlich aufzulösen. Der für eine rasterelektronenmikroskopische Untersuchung der Schicht zu betreibende Aufwand ist jedoch beträchtlich. Das Substrat mit der jeweiligen Schicht muss in eine Hochvakuumapparatur eingebracht werden, denn Elektronenmikroskopie kann nur unter Hochvakuum betrieben werden. Dies bedeutet, dass aus dem Substrat und der Schicht und allen mit ihnen in die Hochvakuumapparatur einzubringenden Substanzen und Gegenständen keine flüchtigen Stoffe mehr austreten dürfen, die das Hochvakuum beeinträchtigen und/oder die Hochvakuumapparatur beschädigen könnten. Auch der Aufwand für die Installation und den Betrieb eines Elektronenmikroskops selbst ist recht hoch. Derzeit werden nur wenige Alternativen zu einer elektronenmikroskopischen Untersuchung bei Verfahren zur Herstellung lithographischer Feinstrukturen gesehen, wenn eine Auflösung im Bereich von unter 150 nm erzielt werden soll. Aktuelle Leiterbahnen in der Mikroelektronik weisen bereits Breiten bis hinab zu 90 nm bei noch schmaleren Leitungsabständen auf. Bei erkennbaren Alternativen zur Elektronenmikroskopie handelt es sich um Verfahren, bei denen die zu untersuchende Feinstruktur mit einer Sonde abgetastet wird. Hierzu zählen die Atomic Force Mikroskopie (AFM) und die Scanning Neafield Optical Mikroskopie (SNOM), die zwar kein Hochvakuum, aber wie die Rasterelektronenmikroskopie eine exakte und daher aufwändige Ausrichtung der gereinigten Feinstruktur gegenüber der empfindlichen Anordnung zum Verfahren der jeweiligen Sonde erfordern und bezogen auf die Größe der untersuchten Feinstruktur extrem langsam sind. Der Aufwand der mikroskopischen Untersuchung bei dem bekannten Verfahren erscheint demnach nur dadurch signifikant reduzierbar zu sein, dass nicht alle lithographisch erzeugten Feinstrukturen untersucht werden, sondern nur wenige Stichproben. Dies erhöht aber die Gefahr fehlerhaft produzierter elektrischer Bauteile ganz erheblich.

Ein Verfahren mit den Merkmalen des Oberbegriffs des Patentanspruchs 1 ist aus der US 2003/0036006 A1 bekannt. Hier wird ein Photoresist mit einem Luminophor dotiert, der so auf den Photoresist abgestimmt ist, dass er ein unterschiedliches Fluoreszenzverhalten, d.h. eine andere Wellenlänge des Fluoreszenzlichts, aufweist, je nachdem ob er in einem belichteten oder einem unbelichteten Bereich des Photoresists vorliegt. Mit herkömmlicher Fluoreszenzmikroskopie, d. h. einer örtlichen Auflösung in der Größenordnung der Wellenlänge des Fluoreszenzlichts, wird der belichtete Photoresist analysiert. Dabei wird die in dem Photoresist durch die Belichtung erzeugte Struktur auch entlang einer betrachteten Linie über den Photoresist nicht direkt abgebildet, sondern es wird festgestellt, ob das Fluoreszenzlicht mit der räumlichen Frequenz der gewünschten Feinstruktur eine gewisse Intensitätsmodulation aufweist. Wenn diese Intensitätsmodulation vorliegt, wird davon ausgegangen, dass die Beteuchtungsvorrichtung für die Beleuchtung des Photoresists richtig fokussiert ist. Für das Abbilden der Feinstruktur, die durch die Beleuchtung des Photoresists erzeugt wurde, ist die maximale Intensitätsmodulation von weniger al 10 %, die z.B. bei einer Feinstruktur aus Linien mit einem Abstand von 440 nm bei Fluoreszenzlicht mit einer Wellenlänge von ca. 515 nm registriert wird, völlig unzureichend. Für die eigentliche Abbildung der erzeugten Feinstruktur wird gemäß der US 2003/0036006 A1 auf ein elektronenmikroskopisches Abbildungsverfahren (SEM) zurückgegriffen. Aktuelle Linienabstände bei in der Halbleitertechnik mit Hilfe von Photoresists ausgebildeten Feinstrukturen liegen unterhalb von 100 nm und wären mit dem hier beschriebenen Fluoreszenzmikroskopischen Verfahren in keiner Wese detektierbar.

Ein Verfahren zur fluoreszenzmikroskopischen Untersuchung einer Probe, die bzw. deren interessierende Strukturen zuvor mit einem Fluoreszenzfarbstoff eingefärbt wurde(n), ist beispielsweise aus der DE 101 54 699 A1 bekannt. Ein Fluoreszenzfarbstoff, mit dem die Probe bzw. interessierende Strukturen der Probe in einem davor liegenden Schritt eingefärbt wurde(n), wird zunächst mit einem anregenden optischen Signal in einen angeregten energetischen Zustand gebracht. Bei dieser optischen Anregung gilt die übliche Grenze für die räumliche Auflösung bei optischen Verfahren von λ/(2n sinα), wobei λ die Wellenlänge des eingesetzten Lichts, n der Brechungsindex der Probe und a der Halbaperturwinkel des eingesetzten Objektivs ist. Um diese Grenze zu unterschreiten, wird der optisch angeregte Zustand des Fluoreszenzfarbstoffs mit einem abregenden optischen Signal bis auf einen gewünschten Messpunkt, in dem das abregende optische Signal eine Nullstelle aufweist, wieder abgeregt; d. h. mit dem abregenden optischen Signal wird der Fluoreszenzfarbstoff in der Probe überall außerhalb des Messpunkts zu stimulierter Emission gezwungen. Die Abmessungen des resultierenden fluoreszierenden Messpunkts, d. h. die räumliche Auflösung der verbleibenden Fluoreszenz, kann deutlich unter die übliche optische Auflösungsgrenze abgesenkt werden, indem das abregende optische Signal außerhalb des gewünschten Messpunkts mit einer solchen Intensität auf die Probe aufgebracht wird, dass eine Sättigung bei der Abregung durch stimulierte Emission erreicht wird. So befindet sich der Fluoreszenzfarbstoff in der Probe nur noch in einem sehr eng begrenzten Bereich um die Nullstelle der Intensitätsverteilung des abregenden optischen Signals in dem angeregten Zustand und kann entsprechend nur in diesem räumlich begrenzten Bereich fluoreszieren.

Gemäß Hell, Nature Biotechn., 21, 1347-1355, verhält sich die Größe des fluoreszierenden Messpunkts Δx und damit die Auflösung gemäß Δx ≅ λ/(2n sinα √(I/Iₛ)), wobei λ die Wellenlänge des abregenden optischen Signals, n der Brechungsindex der Probe, α der Halbaperturwinkel des eingesetzten Objektivs, I die eingestrahlte Intensität des abregenden optischen Signals und Iₛ die Sättigungsintensität ist. Die Sättigungsintensität Iₛ ist die charakteristische Intensität, bei der der Fluoreszenzfarbstoff in der Probe durch die Einwirkung des abregenden optischen Signals statistisch gesehen zur Hälfte abgeregt ist.

Neben diesem als STED(= Stimulated Emission Depletion)-Fluoreszenzmikroskopie bekannten Verfahren ist als weiteres Möglichkeit, die Brechungsgrenze bei der Lichtmikroskopie zu unterschreiten die GSD(= Ground State Depletion)-Fluoreszenzmikroskopie bekannt. Hier wird der Fluoreszenzfarbstoff, statt ihn nach seiner Anregung außerhalb des gewünschten Messpunkts wieder abzuregen, um ihn in einen nicht-fluoreszierenden Zustand zu überführen, außerhalb des gewünschten Messpunkts schon vor seiner Anregung reversibel in einen Zustand versetzt, aus dem heraus er erst gar nicht zur Fluoreszenz anregbar ist.

### AUFGABE DER ERFINDUNG

Der Erfindung liegt die Aufgabe zugrunde, ein Verfahren zur Herstellung räumlicher Feinstrukturen mit den Schritten des Oberbegriffs des Patentanspruchs 1 aufzuzeigen, bei dem auch die Ausbildung von Feinstrukturen mit einer Abmessung von weniger als 100 nm mit deutlich weniger Aufwand als bisher überwachbar ist und das es dadurch erlaubt, mit vertretbarem Aufwand mehr oder sogar alle der hergestellten Feinstrukturen mikroskopisch zu untersuchen.

### LÖSUNG

Die Aufgabe der Erfindung wird durch ein Verfahren zur Herstellung räumlicher Feinstrukturen mit den Schritten des unabhängigen Patentanspruchs 1 gelöst. Vorteilhafte Ausführungsformen des neuen Verfahrens sind in den Unteransprüchen 2 bis 15 definiert.

### BESCHREIBUNG DER ERFINDUNG

Bei dem neuen Verfahren zur Herstellung räumlicher Feinstrukturen wird dem Material, aus dem anschließend die Feinstruktur ausgebildet wird, ein Luminophor zugegeben, der für das eigentliche Ausbilden der Feinstruktur nicht notwendig ist. Auf das Zugeben des Luminophors zu dem Material für die Feinstruktur kann nur dann verzichtet werden, wenn das Material einen solchen Luminophor bereits von sich aus aufweist. Dies ist in aller Regel jedoch nicht der Fall. Nach dem Ausbilden der Feinstruktur aus dem den Luminophor enthaltenden Material kann durch Messen von Lumineszenzlicht, das von dem Luminophor emittiert wird, überprüft werden, ob die Feinstruktur in der gewünschten Form vorliegt.

Als Luminophor zur Verwendung bei dem neuen Verfahren sind vor allem, aber nicht ausschließlich Fluoreszenzfarbstoffe geeignet. Der hinter der Lumineszenz des Luminophors stehende physikalische Vorgang ist nicht entscheidend; es muss sich nicht um Fluoreszenz handeln. Wenn im Folgenden auf einen Fluoreszenzfarbstoff als Beispiel für den Luminophor zur Verwendung bei dem neuen Verfahren näher eingegangen wird, so ist auch dies nicht so zu verstehen, dass die in dem jeweiligen Zusammenhang gemachten Aussagen nur auf einen Fluoreszenzfarbstoff zutreffen. Vielmehr ist der Begriff Fluoreszenzfarbstoff, soweit sich aus dem konkreten Zusammenhang nichts anderes ergibt, als Synonym für den Begriff Luminophor zu verstehen. Dasselbe gilt für Fluoreszenzlicht als Beispiel für Lumineszenzlicht.

Das Messen von Lumineszenzlicht, das von dem Luminophor emittiert wird, erfolgt bei dem neuen Verfahren im Rahmen des mikroskopischen Überprüfens, ob die gewünschte Feinstruktur vorliegt. D. h., es handelt sich um ein Vorgehen, das auch als Lumineszenzmikroskopie bezeichnet werden kann. Als konkretes Beispiel hierfür wird im Folgenden auf die Fluoreszenzmikroskopie verwiesen werden, wobei aber entsprechendes gilt wie oben in Bezug auf den Fluoreszenzfarbstoff als Beispiel für den Luminophor: Der Begriff der Fluoreszenzmikroskopie bzw. des fluoreszenzmikroskopischen Untersuchens ist hier, soweit sich aus dem konkreten Zusammenhang nichts anderes ergibt, als Synonym für das Messen von Lumineszenzlicht von dem Luminophor mit räumlicher Auflösung zu verstehen.

In der Fluoreszenzmikroskopie gibt es verschiedene als solche bekannte Maßnahmen, um die räumliche Auflösung so zu steigern, dass sie für die Untersuchung der künstlichen Feinstrukturen ausreichend hoch ist, die derzeit und in absehbarer Zukunft von kommerziellem Interesse sind. Dabei ist beispielsweise an eine so genannte konfokale Anordnung bei der fluoreszenzmikroskopischen Untersuchung zu denken, aber auch an eine Mehrphotonenanregung des Fluoreszenzfarbstoffs, um die räumliche Zuordnung des aufgefangenen bzw. erzeugten Fluoreszenzlichts zu einem bestimmten Messpunkt zu verbessern.

Bei dem wird ein Luminophor verwendet, der zwei Zustände aufweist, die sich in Bezug auf ihre Lumineszenzeigenschaften unterscheiden, wobei der Luminophor reversibel, aber im Wesentlichen vollständig durch ein optisches Signal von dem einen in den anderen Zustand überführbar ist Damit kann der Luminophor mit dem optischen Signal außerhalb eines räumlichen Bereichs, dessen Abmessung die übliche Grenze für die räumliche Auflösung bei optischen Verfahren von λ/(2n sinα) unterschreitet, in einen Zustand überführt werden, in dem sich die Lumineszenzeigenschaften des Luminosphors von denjenigen innerhalb des Bereichs unterscheiden. Dies erlaubt es, das Lumineszenzlicht von dem Luminophor mit einer räumlichen Auflösung besser als λ/(2n sinα) zu messen, wobei λ die Wellenlänge des optischen Signals zum Überführen des Luminophors von dem einen in den anderen Zustand ist. Von einer im Wesentlichen vollständigen Überführung des Luminophors von seinem einen in seinen anderen Zustand kann dann gesprochen werden, wenn mindestens 80 %, vorzugsweise mindestens 90 %, mehr bevorzugt mindestens 96 % und am meisten bevorzugt mindestens 99 % des Luminophors in den anderen Zustand überführt sind.

Konkret wird der Luminophor beim Messen des Lumineszenzlichts bis auf interessierende Messpunkte in einen inaktiven Zustand überführt werden, in dem er kein Lumineszenzlicht emittiert. Indem dies durch einen bis zur Sättigung angeregten Übergang zwischen den Zuständen des Luminophors erfolgt, wobei die Anregung des Übergangs nur an dem jeweils interessierenden Messpunkt eine Nullstelle aufweist, kann eine ganz erhebliche Steigerung der räumlichen Auflösung beim Messen des Lumineszenzlichts erzielt werden.

Insbesondere kann der Luminophor durch stimulierte Emission aus einem zuvor angeregten Zustand bis auf die interessierenden Messpunkte in einen inaktiven Zustand überführt werden, so dass er nur in den interessierenden Messpunkten in dem angeregten Zustand verbleibt und aufgefangenes Lumineszenzlicht so nur aus diesen interessierenden Messpunkten stammen kann. Dasselbe Ergebnis wird erzielt, wenn der Fluoreszenzfarbstoff überall außerhalb des Messpunkts beispielsweise durch Entvölkerung seines Grundzustands in einen überhaupt nicht lumineszenzfähigen Zustand überführt wird.

Eine erhöhte räumliche Auflösung ist auch durch eine inverse Überführung des Luminophors überall außerhalb der jeweils interessierenden Messpunkte in einen aktiven Zustand möglich. Das interessierende Signal mit der erhöhten räumlichen Auflösung ist dann das reduzierte oder sogar ganz fehlende Lumineszenzlicht aus den Messpunkten.

Der Luminophor kann dem Material, aus dem die Feinstruktur ausgebildet wird, in einer Konzentration von 10⁻⁸ Mol/Liter bis 10⁻² Mol/Liter zugesetzt werden. Vorzugsweise wird er in einer Konzentration von 10⁻⁷ Mol/Liter bis 10⁻⁸ Mol/Liter zugesetzt. Es reicht also ein vergleichsweise geringer Anteil des Luminophors aus, um die erzeugte Feinstruktur durch Messen seines Lumineszenzlichts mikroskopisch untersuchen zu können. Mit anderen Worten sind keine Störungen der Chemie der Feinstruktur durch den Luminophor zu erwarten, wenn dieser in geeigneter Weise aus den bekannten Luminophoren ausgewählt wird.

Das neue Verfahren kann bei der Herstellung verschiedener künstlicher Feinstrukturen angewendet werden. Dabei kann die Feinstruktur eine Feinstruktur sein, die als solche bei einem Endprodukt beispielsweise der Mikroelektronik vorhanden ist. So kann die Feinstruktur zum Beispiel selbst Leiterbahnen ausbilden. Bei der Feinstruktur kann es sich aber auch um eine temporäre Struktur handeln, wie beispielsweise eine Maske, die anschließend zur Herstellung einer zu ihr komplementären weiteren Feinstruktur verwendet wird und die dann wieder entfernt wird, so dass sie selbst bei dem entsprechenden Endprodukt nicht mehr vorhanden ist.

Ein konkreter und besonders bevorzugter Anwendungsbereich des neuen Verfahrens ist die lithographische Herstellung räumlicher Feinstrukturen. Hierzu wird von einem strahlungsempfindlichen Material ausgegangen, und zum Ausbilden der Feinstruktur wird eine Schicht aus dem Material auf ein Substrat aufgetragen, die aufgetragene Schicht in definierten räumlichen Bereichen bestrahlt und die bestrahlte Schicht entwickelt, wobei Teile der Schicht entfernt werden und die gewünschte Feinstruktur zurückbleibt.

Das strahlungsempfindliche Material kann bei dem neuen Verfahren gegenüber UV-Strahlung und/oder Röntgenstrahlung und/oder Elektronenstrahlung empfindlich sein, wobei eine dieser Strahlungsarten zum Bestrahlen der aufgetragenen Schicht in den definierten räumlichen Bereichen verwendet wird.

Wenn im Zusammenhang mit der vorliegenden Erfindung von der lithographischen Herstellung von Feinstrukturen die Rede ist, ist damit normalerweise ein photolithographisches Verfahren gemeint. Die allgemeinere Angabe ohne den Bestandteil "photo" wird hier jedoch bewusst verwendet, um einen Elektronenstrahl oder einen anderen Teilchenstrahl, der nicht unter den Oberbegriff der Photolithographie fallen würde, für die Bestrahlung des strahlungsempfindlichen Materials ausdrücklich nicht auszuschließen.

Wie bereits in den Ausführungen zum Stand der Technik angesprochen wurde, können beim Entwickeln der Schicht deren bestrahlte oder deren nicht bestrahlte räumliche Bereiche entfernt werden.

Bei dem neuen lithographischen Verfahren kann die Schicht nicht erst nach ihrem Entwickeln auf das Vorliegen der gewünschten Feinstruktur untersucht werden, sondern dies ist bereits vorher möglich, wenn durch das Bestrahlen der Schicht nicht nur das eigentliche Material der Schicht in seinem Zustand verändert wird, sondern auch eine dauerhafte Umwandlung, d. h. in der Regel eine Zerstörung, des Luminophors erfolgt, wovon typischerweise ausgegangen werden kann. So kann mit dem Untersuchen der Schicht direkt nach ihrem Bestrahlen festgestellt werden, ob das Bestrahlen tatsächlich in den hierfür vorgesehenen definierten räumlichen Bereichen erfolgte, oder ob solche Bereiche ausgelassen wurden bzw. ob ungewollte Bereiche bestrahlt wurden.

Wenn das von dem Luminophor emittierte Lumineszenzlicht beim Untersuchen der Schicht auf das Vorliegen der gewünschten Feinstruktur mit mindestens einem optischen Element abgebildet wird, das auch zum Bestrahlen der aufgetragenen Schicht verwendet wird, wird dieses optische Element doppelt genutzt und muss gegenüber der Schicht nur einmal ausgerichtet werden. Grundsätzlich ist sogar daran zu denken, die gesamte relevante Optik sowohl zum Bestrahlen der aufgetragenen Schicht als auch zum Untersuchen der Schicht auf das Vorliegen der gewünschten Feinstruktur zu verwenden.

Beim Untersuchen der Schicht auf das Vorliegen der gewünschten Feinstruktur kann das von dem Luminophor emittierte Lumineszenzlicht in vorteilhafter Weise mit einem Immersionsobjektiv abgebildet werden. Die mikroskopische Untersuchung der Schicht auf der Basis des Fluoreszenzlichts ist nicht auf einen Brechungsindexunterschied zwischen der Schicht und dem an sie angrenzenden Medium angewiesen. Die Feinstruktur der Schicht wird nicht direkt, d. h. als solche bei dem neuen Verfahren abgebildet, sondern es wird die Verteilung des von dem (noch funktionsfähig vorhandenen) Luminophor emittierten Lumineszenzlichts erfasst, woraus ein indirekter Rückschluss auf die Feinstruktur möglich ist. Durch die Verwendung eines lmmersionsobjektivs mit einem Immersionsmedium, dessen Brechungsindex dem Brechungsindex der interessierenden Schicht möglichst nahe kommt, können die optischen Verhältnisse für eine hohe räumliche Auflösung optimal eingestellt werden.

Besonders bevorzugt bei dem neuen Verfahren ist es jedoch, wenn das Immersionsmedium nicht allein bezüglich seines Brechungsindexes, sondern auch bezüglich seiner rückstandsfreien Entfembarkeit von der untersuchten Feinstruktur optimiert wird. Diesbezüglich besonders geeignet sind vollständig verflüchtigbare Flüssigkeiten, wie beispielsweise hochreines Wasser, die nicht als Lösungsmittel für in der Schicht oder dem darunter liegenden Substrat enthaltene Substanzen wirken. Es ist aber auch an die Verwendung von auf die jeweilige Schicht aufgesetzten Festkörpern als lmmersionsmedien zu denken (d.h. an so genannte Solid Immersion Lenses), oder auch an Kombinationen von Flüssigkeiten und Festkörpern.

Immersionsobjektive werden bereits derzeit bei der Herstellung von lithographischen Feinstrukturen zur Bestrahlung der Schicht mit hoher räumlicher Auflösung verwendet. Diese oder ähnliche lmmersionsobjektive können auch im Rahmen der mikroskopischen Untersuchung der Feinstruktur bei dem neuen Verfahren verwendet werden.

Das neue Verfahren kommt vollständig ohne das Einbringen der Schicht mit der erzeugten Feinstruktur in eine Hochvakuumapparatur aus. Es schafft damit hervorragende Voraussetzungen dafür, mit vertretbarem Aufwand alle erzeugten Feinstrukturen mikroskopisch zu untersuchen. Der Aufwand hierfür ist besonders gering, wenn für die Untersuchung optische Elemente verwendet werden, die auch zum Bestrahlen der Schicht zur Ausbildung der Feinstruktur verwendet werden. Beim Ergreifen der wesentlichen hier beschriebenen aüflösungsfördernden Maßnahmen sind räumliche Auflösungen beim Messen des von dem Luminophor emittierten Lumineszenzlichts möglich, mit denen auch periodische Linienstrukturen von 80 nm Breite und 40 nm Abstand oder noch feinerem Aufbau mit Lumineszenzlicht und optischen Signalen im sichtbaren Bereich analysiert werden können.

Vorteilhafte Weiterbildungen der Erfindung ergeben sich aus den abhängigen Patentansprüchen und der gesamten Beschreibung. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche abweichend von den gewählten Rückbeziehungen ist ebenfalls möglich und wird hiermit angeregt. Dies betrifft auch solche Merkmale, die in separaten Zeichnungsfiguren dargestellt sind oder bei deren Beschreibung genannt werden. Diese Merkmale können auch mit Merkmalen unterschiedlicher Patentansprüche kombiniert werden.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: zeigt ein Blockdiagram zur Durchführung des neuen Verfahrens in einer ersten Ausführungsform.
- **Fig. 2**: zeigt ein Blockdiagramm zur Durchführung des neuen Verfahrens in einer zweiten Ausführungsform.
- **Fig. 3**: zeigt den prinzipiellen Aufbau eines bei dem Verfahren gemäß Fig. 1 oder Fig. 2 eingesetzten Fluoreszenzmikroskops.
- **Fig. 4**: zeigt Abbildungen eines Linienmusters mit abnehmendem Linienabstand durch Rasterelektronenmikroskopie, konfokale Fluoreszenzmikroskopie und STED-Fluoreszenzmikroskople; und
- **Fig. 5**: zeigt Abbildungen verschiedener lithographischer Muster durch konfokale Fluoreszenzmikroskopie und STED-Fluoreszenzmikroskopie.

### FIGURENBESCHREIBUNG

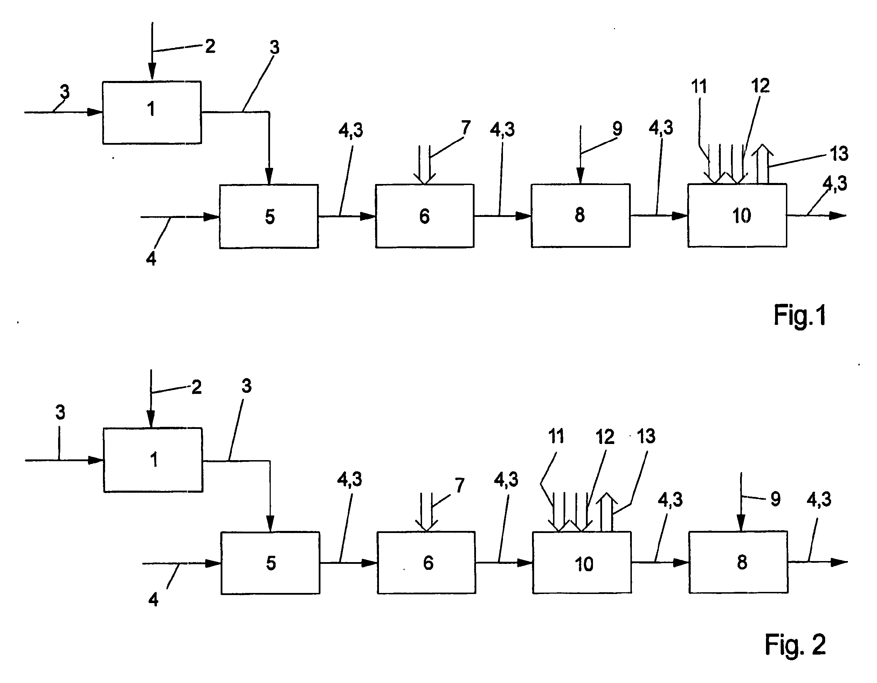

Das in dem Blockdiagramm gemäß **Fig. 1** skizzierte Verfahren beginnt mit dem Schritt des Zusetzens 1 eines Fluoreszenzfarbstoffs 2 zu einem strahlungsempfindlichen Material 3. Die Konzentration, in der der Fluoreszenzfarbstoff 2 dem Material zugesetzt wird, ist typischerweise 10⁻⁷ bis 10⁻⁶ molar. Das mit Fluoreszenzfarbstoff 2 versetzte Material 3 wird dann auf ein Substrat 4 aufgetragen 5, um ein mit einer Schicht aus dem Material 3 versehenes Substrat 4 auszubilden. In einem nachfolgenden Schritt des Bestrahlens 6 mit einer Strahlung 7 wird das strahlungsempfindliche Material 3 der Schicht in definierten räumlichen Bereichen durch die Strahlung 7 grundsätzlich verändert. Das derart veränderte Material 3 wird in einem folgenden Schritt des Entwickelns 8 unter Einsatz eines Entwicklers 9 entfernt, so dass nur das zuvor nicht bestrahlte Material 3 auf dem Substrat 4 verbleibt. Die von dem verbleibenden Material 3 auf dem Substrat ausgebildete Feinstruktur wird in einem Schritt des fluoreszenzmikroskopischen Untersuchens 10 daraufhin untersucht, ob genau die Feinstruktur vorliegt, die durch das Bestrahlen 6 mit der Strahlung 7 ausgebildet werden sollte. Für das fluoreszenzmikroskopische Untersuchen 10 wird der Fluoreszenzfarbstoff 2 in dem Material 3 mit einem Anregungslichtstrahl 11 angeregt, aber überall außerhalb interessierender Messpunkte mit einem Abregungslichtstrahl 12 wieder abgeregt, so dass Fluoreszenzlicht 13, das beim fluoreszenzmikroskopische Untersuchen 10 analysiert wird, jeweils nur einem sehr eng begrenzten räumlichen Bereich entstammt. Am Ende des Verfahrens gemäß Fig. 1 steht das Substrat 4, auf dem das Material 3 nachweislich die gewünschte und durch das Bestrahlen 6 mit der Strahlung 7 festgelegte Feinstruktur ausbildet.

Die in **Fig. 2** skizzierte Variante des Verfahrens unterscheidet sich von derjenigen gemäß Fig. 1 erst nach dem Schritt des Bestrahlens 6. Gemäß Fig. 2 wird direkt anschließend, d. h. noch vor dem Entwickeln 8, fluoreszenzrnikroskopisch untersucht 10, ob durch die Strahlung 7 die gewünschte Feinstruktur des Materials 3 auf dem Substrat 4 ausgebildet wurde. Dabei geht das Verfahren gemäß Fig. 2 davon aus, dass durch die Strahlung 7 nicht nur das Material 3 selbst, sondern auch der ihn zugesetzte Farbstoff 2 dauerhaft verändert wird, so dass nicht erst nach dem Entwickeln 8, d. h. nach dem Entfernen der bestrahlten Anteile des Materials 3, die Verteilung des noch funktionsfähig vorhandenen Fluoreszenzfarbstoffs 2 die mit der Strahlung 7 erzeugte Feinstruktur anzeigt. Diese Feinstruktur kann vielmehr direkt nach dem Bestrahlen 6 untersucht 10 werden, und das Entwickeln 8 kann sich hieran anschließen. Dadurch müssen nur die Schichten entwickelt werden, bei denen die gewünschte Feinstruktur durch die Strahlung 7 tatsächlich ausgebildet wurde, was durch das Untersuchen 10 festgestellt wurde. Überdies kann, wenn für das Abbilden der Strahlung 7 in das Material 3 der Schicht auf dem Substrat 4 z.B. ein lmmersionsobjektiv verwendet wird, dasselbe Immersionsobjektiv auch für das Abbilden des Anregungslichtstrahls 11 und des Abregungslichtstrahls 12 sowie das Auffangen von Fluoreszenzlicht 13 von dem Fluoreszenzfarbstoff 2 verwendet werden.

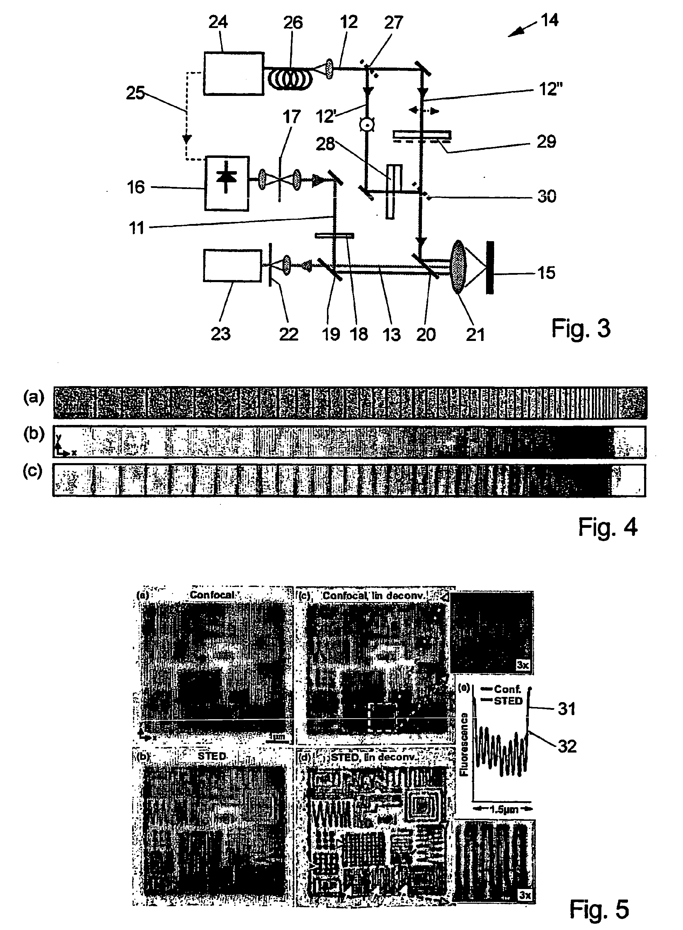

**Fig. 3** zeigt den prinzipiellen Aufbau eines Fluoreszenzmikroskops, das in dem Schritt des Untersuchens 10 gemäß den Figuren 1 und 2 eingesetzt werden kann. Das Fluoreszenzmikroskop 14 weist zum Anregen des Fluoreszenzfarbstoffs in einer Probe 15 eine Anregungslichtquelle 16 auf, bei der es sich um eine gepulste Laserdiode (PicoQuant GmbH, Deutschland) handelt, die den Anregungslichtstrahl 11 mit einer Wellenlänge von 635 nm in 68 ps Pulsen mit einer Wiederholungsrate von 80 MHz abgibt. Der Anregungslichtstrahl 11 wird von der Anregungslichtquelle 16 aus durch eine Lochblende 17 geführt und gelangt dann durch eine Lambda-Viertel-Platte, die dazu führt, dass der Anregungslichtstrahl 11 zirkular polarisiert wird. Nach Ablenkung durch einen dichroitischen Spiegel 19 gelangt der Anregungslichtstrahl 11 durch einen weiteren dichroitischen Spiegel 20 in ein Objektiv 21 und wird von diesem in die Probe 15 fokussiert Das Objektiv 21 ist hier ein Ölimmersionsobjektiv mit einer numerischen Apertur von 1,4 (Planapo 1,4 NA, Leica Mircrosystems, Wetzlar, Germany). Die dichroitischen Spiegel 19 und 20 und weitere nicht dargestellte Filter sind auf die Wellenlänge des Anregungslichtstrahls 11 von 635 nm und einen Emissionsbereich des Fluoreszenzfarbstoffs in der Probe 15 von 650 bis 710 nm abgestimmt, wobei dies die Charakteristika des Xanthen-Fluoreszenzfarbstoffs JA 26 sind. Fluoreszenzlicht 13 aus der Probe wird durch das Objektiv 21 eingefangen und auf eine Lochblende 22 vor einem Photodetektor 23 abgebildet. Die Lochblende 22 ist in Bezug auf die Lochblende 17 im Strahlengang des Anregungslichtstrahls 11 konfokal angeordnet. Die Lochblende 22 und der Photodetektor 23 können durch eine Lichtleiterfaser, die das Licht zu einer zählenden Lawinenphotodiode leitet, realisiert sein. Dabei kann der Kerndurchmesser der Lichtleiterfaser bei Abbildung in die Brennebene des Objektivs 21 dem 0,7-fachen der Airy-Scheibe entsprechen.

Dieser Aufbau eines konfokalen Fluoreszenzmikroskops ist um folgende Bestandteile zu einem STED-Fluoreszenzmikroskop erweitert, wobei bereits der dichroitische Spiegel 20 dieser Erweiterung zuzurechnen ist. Bei einem STED-Mikroskop werden durch Entvölkem des angeregten Zustands des Fluoreszenzfarbstoffs mittels stimulierter Emission (Stimulated Emission Depletion) in allen Bereichen außerhalb eines interessierenden Messpunkts, die Abmessungen des Volumens, in dem der Fluoreszenzfarbstoff noch angeregt ist, so dass er Fluoreszenzlicht 13 emittieren kann, reduziert. Für den entsprechenden Abregungslichtstrahl 12 weist das Fluoreszenzmikroskop 14 eine Abregungslichtquelle 24 auf, bei der es sich hier um einen im Femtosekundenbereich phasengekoppelten Ti:Saphirlaser (Mai Tai, Spectra Physics) handelt, der den Abregungslichtstrahl 12 mit einer Wellenlänge von 780 nm abgibt und gleichzeitig über ein Triggersignal 25 als Taktgeber für die Anregungslichtquelle 16 dient. Die von der Abregungslichtquelle 24 abgegebenen rotverschobenen Pulse werden durch eine Einmodenfaser von 100 m Länge geleitet, um sie auf eine Pulsdauer von 300 ps zu strecken. Damit sind die Pulse des Abregungslichtstrahls 12 deutlich länger als diejenigen des Anregungslichtstrahls 11 von 68 ps. Auf diese Weise ist eine unerwünschte Anregung des Fluoreszenzfarbstoffs, die nicht wieder abgeregt wird, ausgeschlossen. Die Einmodenfaser 26 lässt die Polarisierung des Abregungslichtstrahls 12 unbeeinträchtigt, der anschließend durch einen polarisierenden Strahlteiler 27 in zwei Teilstrahlen 12' und 12" mit zueinander senkrechter s- bzw. p-Polarisation aufgespalten wird. Nach Durchlaufen von Phasenplatten 28 und 29, die die Polarisation der Teilstrahlen 12' und 12" aufeinander abstimmen, werden die Teilstrahlen 12' und 12" durch einen weiteren polarisierenden Strahlteiler 30 wieder so überlagert, dass der mit dem Objektiv 21 in die Probe 15 abgebildete Abregungslichtstrahl 12 einen torusförmigen Bereich mit Intensität > 0 ausbildet, in dessen Zentrum das lnterferenzmuster ein Minimum, d. h. eine Intensität von 0 aufweist. In diesem Bereich wird die Anregung des Fluoreszenzfarbstoffs in der Probe 15 durch den Anregungslichtstrahl 11 nicht wieder abgeregt, während überall außerhalb eine Abregung durch den Abregungslichtstrahl 12 erfolgt. Auf diese Weise kann die Auflösung des Fluoreszenzmikroskops 14 unter die Beugungsgrenze des für die Anregung der Probe verwendeten Anregungslichtstrahls 11 abgesenkt werden.

**Fig. 4** zeigt Abbildungen einer Feinstruktur, die wie folgt hergestellt wurde. Als Material 3 wurde Polymethylmethakrylat (PMMA, Molekulargewicht ca. 450.000, 40 µM) in (2-Methoxylethyl)-Azetat mit dem Fluoreszenzfarbstoff JA 26 versetzt (Molekulargewicht ca. 500, 100 µM). Dieses versetzte Material 3 wurde auf ein Substrat 4 aus Silizium in einer Schichtdicke von 40 bis 50 nm aufgetragen und dann für eine Stunde bei 110 °C gebacken, um Lösungsmittelreste zu entfernen. Anschließend wurde in die gebackene Schicht mit einem Eiekironensirahi (5 kV, 0,1 mC/cm) geschrieben, wodurch das Aufbrechen von Bindungen in der PMMA-Polymerkette induziert wurde, was die differenzielle Löslichkeit des PMMA erhöhte. Anschließend wurde die bestrahlte Schicht mit einer Entwicklungslösung in Form eines Lösungsmittels (Ethylengylkolmonoethylether und Ethylenglykolmonobutylether 4:1, 45 s Einwirkungszeit) entwickelt. PMMA, das hierbei aus der Schicht herausgelöst werden sollte, musste mehrere Bindungsbrechungen pro Polymerkette durch die Bestrahlung aufweisen. Diese Nichtlinearität bei der induzierten Löslichkeit des PMMA erzeugte vergleichsweise scharfe Kanten, wie bei einer Abbildung der erzielten PMMA-Struktur durch Rasterelektronenmikroskopie (siehe Fig. 4(a)) deutlich wurde. Der im vorliegenden Fall zugesetzte Fluoreszenzfarbstoff 2, der dem PMMA zugesetzt war, wurde bereits durch das Aufbrechen einer Bindung innerhalb des Farbstoffmoleküls gebleicht, d. h. inaktiv. Entsprechend sind die Bereiche, in denen der Farbstoff nach dem Bestrahlen des PMMA mit dem Elektronenstrahl zerstört ist, weniger scharf begrenzt als die Kanten der entfernten bzw. verbleibenden Bereiche des PMMA selbst. Dennoch sind in Fig. 4(c), das eine Abbildung derselben Struktur wie in Fig. 4(a) durch STED-Fluoreszenzmikroskopie zeigt, bis herab zu einem geringen Abstand von etwa 40 nm dieselben Linien getrennt voneinander zu erkennen. In der konfokalen fluoreszenzmikroskopischen Abbildung gemäß Fig. 4(b) sind die Linien hingegen nur bei einem sehr viel größeren Abstand voneinander zu unterscheiden.

**Fig. 5(a)** bis **(d)** zeigt vier verschiedene Abbildungen derselben Strukturen, die gemäß der Beschreibung zu Fig. 4 erzeugt wurden. Fig. 5(a) ist eine konfokale fluoreszenzmikroskopische Abbildung; hier sind die Strukturen kaum aufgelöst. Die Abbildung gemäß Fig. 4(b) ist eine STED-fluoreszenzmikroskopische Abbildung und löst die Strukturen bereits recht gut auf. Sehr deutlich sind die Strukturen in Fig. 5(d) erkennbar, die die Abbildung gemäß Fig. 5(b) nach Verstärken der höheren Raumfrequenzen des Bildes durch einen numerischen Wiener-Filter zeigt. Hier sind Muster mit einem Linienabstand von 80 nm (weiße Pfeile) aufgelöst. Ein Muster mit einem Linienabstand von 140 nm (weiße Pfeilspitze) ist noch deutlicher aufgelöst. Ein Muster mit einem Linienabstand von 200 nm (schwarze Pfeilspitze) tritt sehr deutlich hervor. Die Auflösung eines der Muster mit dem Linienabstand von 80 nm geht aus dem dreifach vergrößerten Detail gemäß Fig. 5(d) besonders deutlich hervor. Fig. 5(c) ist die entsprechend Fig. 5(d) bearbeitete Abbildung gemäß Fig. 5(a). Hier ist auch in der dreifachen Vergrößerung des Details die betrachtete Struktur nicht aufgelöst. Die Unterschiede zwischen den Abbildungen der Fig. 5(c) und 5(d) bezüglich des vergrößerten Details gehen besonders deutlich aus Fig. 5(e) hervor. Hier ist die Intensität des Fluoreszenzlichts über einen in Bezug auf die Darstellung horizontalen Schnitt auf halber Höhe durch den vergrößerten Bereich aufgetragen. Das räumliche Profil 31, das zu der STED-fluoreszenzmikroskopischen Abbildung gehört, zeigt eine deutliche Intensitätsmodulation mit der räumlichen Position der betrachteten Struktur, während das räumliche Profil 32, das zu der konfokalen Abbildung gehört, nur die Ränder der betrachteten Struktur erkennen lässt. Die Intensitätsmodulation des Profils 31 beträgt selbst bezogen auf das maximale Signal am rechten Rand des Schnitts mehr als 20 %. Innerhalb des Schnitts beträgt die Intensitätsmodulation zwischen den Minima und den Maxim bezogen auf die Maxima des Fluoreszenzlichts mindestens 30 %.

### BEZUGSZEICHENLISTE

| | | | |
|---|---|---|---|
| 1 | Zusetzen | 11 | Anregungslichtstrahl |
| 2 | Fluoreszenzfarbstoff | 12 | Abregungslichtstrahl |
| 3 | Material | 13 | Fluoreszenzlicht |
| 4 | Substrat | 14 | Fluoreszenzmikroskop |
| 5 | Auftragen | 15 | Probe |
| 6 | Bestrahlen | 16 | Anregungslichtquelle |
| 7 | Strahlung | 17 | Lochblende |
| 8 | Belichten | 18 | Lambda-Viertel-Platte |
| 9 | Entwickler | 19 | dichroitischer Spiegel |
| 10 | Untersuchen | 20 | dichroitischer Spiegel |
| | | | |
| 21 | Objektiv | 31 | räumliches Profil STED |
| 22 | Lochblende | 32 | räumliches Profil konfokal |
| 23 | Photodetektor | | |
| 24 | Abregungslichtquelle | | |
| 25 | Triggersignal | | |
| 26 | Einmodenfaser | | |
| 27 | Strahlteiler | | |
| 28 | Phasenplatte | | |
| 29 | Phasenplatte | | |
| 30 | Strahlteiler | | |

## Patentansprüche

1. Verfahren zur Herstellung räumlicher Feinstrukturen mit den Schritten:
- Zugeben eines Luminophors zu einem Material,
- Ausbilden einer räumlichen Feinstruktur aus dem Material und
- fluoreszenmiikroskopisch Überprüfen, ob die gewünschte Feinstruktur vorliegt, wobei von dem Luminophor emittiertes Lumineszenzlicht gemessen wird,
**dadurch gekennzeichnet, dass** der Luminophor zwei Zustände aufweist, die sich in Bezug auf ihre Lumineszenzeigenschaften unterscheiden, wobei der Luminophor reversibel, aber im Wesentlichen vollständig durch ein optisches Signal von dem einen in den anderen Zustand überfuhrbar ist und dass der Luminophor beim mikroskopischen Überprüfen, ob die gewünschte Feinstruktur vorliegt, bis auf jeweils interessierende Messpunkte durch einen bis zur Sättigung getriebenen Übergang zwischen seinen beiden Zuständen in einen inaktiven Zustand überführt wird, in dem er kein Lumineszenzlicht emittiert.

2. Verfahren nach Anspruch 1, **dadurch gekennzeichnet, dass** beim Überprüfen ob die gewünschte Struktur vorliegt, Linien in einem Abstand von weniger als 100 nm aufgelöst werden.

3. Verfahren nach Anspruch 2, **dadurch gekennzeichnet, dass** die Intensftätsrnodulation des Lumineszenzlichts bel einem Schnitt durch die linien mindestens 20 % beträgt.

4. Verfahren einem der Ansprüche 1 bis 3, **dadurch gekennzeichnet, dass** der Luminophor durch stimulierte Emission in den inaktiven Zustand überführt wird.

5. Verfahren einem der Ansprüche 1 bis 3, **dadurch gekennzeichnet, dass** der Luminophor durch Entvölkerung seines Grundzustands in den inaktiven Zustand überführt wird.

6. Verfahren nach einem der Ansprüche 1 bis 5, **dadurch gekennzeichnet, dass** der Luminophor dem Material (3), aus dem die Feinstruktur ausgebildet wird, in einer Konzentration zwischen 10⁻⁸ Mol/Liter und 10⁻² Mol/Liter, vorzugsweise in einer Konzentration von 10⁻⁷ Mol/Liter und 10⁻⁸ Mol/Liter zugegeben wird.

7. Verfahren nach einem der Ansprüche 1 bis 6, **dadurch gekennzeichnet, dass** das Material (3) strahlungsempfindlich ist und dass zum Ausbilden der Feinstruktur eine Schicht aus dem Material auf ein Substrat aufgetragen wird, die aufgetragene Schicht in definierten räumlichen Bereichen bestrahlt wird und die bestrahlte Schicht entwickelt wird, wobei Teile der Schicht entfernt werden und die gewünschte Feinstruktur zurückbleibt.

8. Verfahren nach Anspruch 7, **dadurch gekennzeichnet, dass** das strahlungsempfindliche Material (3) gegenüber UV-Strahlung und/oder Röntgenstrahlung und/oder Elektronenstrahlung empfindlich ist.

9. Verfahren nach einem der Ansprüche 7 und 8, **dadurch gekennzeichnet, dass** beim Entwickeln (8) der Schicht deren bestrahlte räumliche Bereiche oder deren nicht bestrahlte räumliche Bereiche entfernt werden.

10. Verfahren nach einem der Ansprüche 7 bis 9, **dadurch gekennzeichnet, dass** die Schicht vor ihrem Entwickeln (8) auf das Vorliegen der gewünschten Feinstruktur untersucht wird.

11. Verfahren nach einem der Ansprüche 7 bis 9, **dadurch gekennzeichnet, dass** die Schicht nach ihrem Entwickeln (8) auf das Vorliegen der gewünschten Feinstruktur untersucht wird.

12. Verfahren nach einem der Ansprüche 7 bis 11, **dadurch gekennzeichnet, dass** der Luminophor in den räumlichen Bereichen, in denen die Schicht bestrahlt wird, durch das Bestrahlen der Schicht zerstört wird.

13. Verfahren nach einem der Ansprüche 7 bis 12, **dadurch gekennzeichnet, dass** zum Messen des von dem Luminophor emittierten Lumineszenzlichts mit mindestens einem optischen Element auf einen Detektor abgebildet wird, das auch zum Bestrahlen der aufgetragenen Schicht verwendet wird.

14. Verfahren nach einem der Ansprüche 1 bis 13, **dadurch gekennzeichnet, dass** von dem Luminophor emittiertes Lumineszenzlicht mit einem Immersionsobjektiv auf einen Detektor abgebildet wird.

15. Verfahren nach Anspruch 14, **dadurch gekennzeichnet, dass** als Immersionsionsflüssigkeit für das Immersionsobjektiv eine verflüchtigbare Flüssigkeit verwendet wird.

## Claims

1. Method of producing spatial fine structures comprising the steps of:
- adding a luminophore to a material;
- forming a spatial fine structure from the material and
- fluorescence-microscopically examining whether the desired fine structure is present, wherein luminescence light emitted by the luminophore is measured,
**characterized in that** the luminophore has two different states which differ with regard to their luminescence properties, wherein the luminophore is reversibly, but essentially completely, transferable out the one state into the other state by means of an optical signal, and that the luminophore, outside measuring points of interest, by means of a transfer between its two states driven up to saturation, is transferred into an inactive state in which it does not emit luminescence light during microscopically examining whether the desired fine structure is present.

2. Method of claim 1, **characterized in that**, in examining whether the desired fine structure is present, lines at a distance of less than 100 nm are resolved.

3. Method of claim 2, **characterized in that** the intensity modulation of the luminescence light in a section through the lines amounts to at least 20 %.

4. Method of any of the claims 1 to 3, **characterized in that** the luminophore is transferred into the inactive state by stimulated emission.

5. Method of any of the claims 1 to 3, **characterized in that** the luminophore is transferred into the inactive state by depletion of its ground state.

6. Method of any of the claims 1 to 5, **characterized in that** the luminophore is added to the material (3) from which the fine structure is formed at a concentration between 10⁻⁸ Mol/liter and 10⁻² Mol/liter, preferably at a concentration between 10⁻⁷ Mol/liter and 10⁻⁶ Mol/liter.

7. Method of any of the claims 1 to 6, **characterized in that** the material (3) is radiation sensitive, and that for forming the fine structure a layer of the material is deposited onto a substrate, the deposited layer is irradiated within spatially defined areas, and the irradiated layer is processed, wherein parts of the layer are removed and the desired fine structure remains.

8. Method of claim 7, **characterized in that** the radiation sensitive material (3) is sensitive to UV radiation and/or X radiation and/or electron radiation.

9. Method of any of the claims 7 and 8, **characterized in that** in processing (8) of the layer its irradiated spatial areas or its not irradiated spatial areas are removed.

10. Method of any of the claims 7 to 9, **characterized in that** the layer prior to its processing (8) is examined for the presence of the desired fine structure.

11. Method of any of the claims 7 to 9, **characterized in that** the layer after its processing (8) is examined for the presence of the desired fine structure.

12. Method of any of the claims 7 to 11, **characterized in that** the luminophore, in the spatial areas in which the layer is irradiated, is destroyed by the irradiation of the layer.

13. Method of any of the claims 7 to 12, **characterized in that**, for measuring the luminescence light emitted by the luminophore, at least one optical element is used which is also used for irradiating the layer deposited.

14. Method of any of the claims 1 to 13, **characterized in that** luminescence light emitted by the luminophore is imaged onto a detector by an immersion objective.

15. Method of claim 14, **characterized in that** a volatilizable liquid is used as an immersion liquid for the immersion objective.

## Revendications

1. Procédé de réalisation de structures spatiales fines comprenant les étapes suivantes :
- ajout d'un luminophore à un matériau,
- réalisation d'une structure spatiale fine à partir du matériau et
- vérification, par microscopie à fluorescence, de l'existence de la structure fine souhaitée, la luminescence émise par le luminophore étant mesurée,
**caractérisé en ce que** le luminophore présente deux états qui se différencient par leurs propriétés de luminescence, le luminophore pouvant être amené de manière réversible mais essentiellement complètement dans l'un ou l'autre état grâce à un signal optique et **en ce que** le luminophore est amené, lors de la vérification microscopique de l'existence de la structure fine souhaitée, jusqu'à des points de mesure intéressants, grâce à une transition portée à saturation entre ses deux états, dans un état inactif dans lequel il n'émet aucune luminescence.

2. Procédé selon la revendication 1, **caractérisé en ce que**, lors de la vérification de l'existence de la structure, des lignes à une distance de moins de 100 nm peuvent être distinguées.

3. Procédé selon la revendication 2, **caractérisé en ce que** la modulation d'intensité de la luminescence est d'au moins 20% lors d'une coupe à travers les lignes.

4. Procédé selon l'une des revendications 1 à 3, **caractérisé en ce que** le luminophore est amené dans l'état inactif grâce à une émission stimulée.

5. Procédé selon l'une des revendications 1 à 3, **caractérisé en ce que** le luminophore est amené dans l'état inactif grâce au dépeuplement de son état de base.

6. Procédé selon l'une des revendications 1 à 5, **caractérisé en ce que** le luminophore est ajouté au matériau (3), dont est constituée la structure fine, dans une concentration entre 10⁻⁸ mol/l et 10⁻² mol/l, de préférence dans une concentration de 10⁻⁷ mol/l et 10⁻⁶ mol/l.

7. Procédé selon l'une des revendications 1 à 6, **caractérisé en ce que** le matériau (3) est sensible aux rayonnements et **en ce que**, pour la formation de la structure fine, une couche de matériau est appliquée sur un substrat, la couche appliquée est irradiée dans des zones définies spatialement et la couche irradiée est développée, des parties de la couche étant éliminées et la structure fine souhaitée subsistant.

8. Procédé selon la revendication 7, **caractérisé en ce que** le matériau sensible au rayonnement (3) est sensible au rayonnement UV et/ou aux rayons X et/ ou au rayonnement électronique.

9. Procédé selon l'une des revendications 7 et 8, **caractérisé en ce que**, lors du développement (8) de la couche, ses zones spatiales irradiées ou ses zones spatiales non irradiées sont éliminées.

10. Procédé selon l'une des revendications 7 à 9, **caractérisé en ce que** la couche est examinée, avant son développement (8), afin de vérifier l'existence de la structure fine souhaitée.

11. Procédé selon l'une des revendications 7 à 9, **caractérisé en ce que** la couche est examinée, après son développement (8), afin de vérifier l'existence de la structure fine souhaitée.

12. Procédé selon l'une des revendications 7 à 11, **caractérisé en ce que** le luminophore est détruit par l'irradiation de la couche dans les zones spatiales dans lesquelles la couche est irradiée.

13. Procédé selon l'une des revendications 7 à 12, **caractérisé en ce que**, pour la mesure de la luminescence émise par le luminophore avec au moins un élément optique est représentée sur un détecteur qui est utilisé également pour l'irradiation de la couche appliquée.

14. Procédé selon l'une des revendications 1 à 13, **caractérisé en ce que** la luminescence émise par le luminophore est représentée avec un objectif à immersion sur un détecteur.

15. Procédé selon la revendication 14, **caractérisé en ce que** le liquide d'immersion utilisé pour l'objectif à immersion est un liquide volatil.
